Europäisches Patentamt

(19) European Patent Office

Office européen des brevets

(11) Numéro de publication : **0 184 483**
**B1**

(12) **FASCICULE DE BREVET EUROPÉEN**

(45) Date de publication du fascicule du brevet :
26.04.89

(51) Int. Cl.⁴ : **H 03 F   1/34**, H 03 F   3/191

(21) Numéro de dépôt : 85402168.0

(22) Date de dépôt : 08.11.85

(54) Amplificateur à large bande et faible bruit en ondes métriques.

(30) Priorité : 13.11.84 FR 8417295

(43) Date de publication de la demande :
11.06.86 Bulletin 86/24

(45) Mention de la délivrance du brevet :
26.04.89 Bulletin 89/17

(84) Etats contractants désignés :
DE GB IT

(56) Documents cités :
FR-A- 1 210 902
GB-A- 1 590 647
MICROWAVE JOURNAL, vol. 25, no. 10, octobre 1982,
pages 130-136, Dedham, Massachusetts, US; A. RUS-
SELL: "Amplifier application notes"

(73) Titulaire : THOMSON-CSF
173, Boulevard Haussmann
F-75379 Paris Cédex 08 (FR)

(72) Inventeur : Collin, Robert
THOMSON-CSF SCPI 173, bld Haussmann
F-75379 Paris Cedex 08 (FR)

(74) Mandataire : Turièque, Clotilde et al
THOMSON-CSF SCPI
F-92045 PARIS LA DEFENSE CEDEX 67 (FR)

EP 0 184 483 B1

**Description**

L'invention se rapporte à un amplificateur large bande et faible bruit en ondes métriques, particulièrement adapté à une utilisation dans un récepteur ondes métriques (VHF) susceptible de fonctionner en même temps qu'un émetteur dont l'antenne est fortement couplée a celle du récepteur.

Le problème à résoudre dans ce type d'amplificateur est d'obtenir un produit gain bande passante aussi élevé que possible, tout en maintenant un facteur de bruit correct. En présence de signaux brouilleurs d'amplitude élevée, par exemple en présence d'une émission par un émetteur situé à proximité, il est en effet important que la linéarité reste bonne et, dans ce cas on admet une légère détérioration du facteur de bruit.

Classiquement ce type d'amplificateur comporte un transistor monté en émetteur commun, associé à un transformateur de contre réaction entre la sortie et l'entrée de l'amplificateur, c'est-à-dire entre le collecteur du transistor et sa base. De ce fait une tension haute fréquence élevée est présente aux bornes du transformateur, et les capacités parasites des enroulements de contre-réaction sont gênantes car elles limitent la bande passante.

L'invention a pour objet un amplificateur large bande et faible bruit en ondes métriques qui ne présente pas ces inconvénients et qui en particulier présente un produit gain-bande passante élevé du fait de la réduction des capacités parasites, obtenue par une structure particulière du schéma électrique.

Suivant l'invention un amplificateur à large bande et faible bruit, en ondes métriques, comportant un transistor associé à un circuit à transformateur de contre-réaction, est caractérisé en ce que le circuit à transformateur comporte deux transformateurs, le primaire du premier étant branché entre l'émetteur du transistor et sa base, le primaire du second étant branché entre le collecteur du transistor et le point de potentiel commun, et les secondaires de ces deux transformateurs étant branchés en série dans le circuit d'émetteur du transistor, le signal de sortie de l'amplificateur étant prélevé sur une partie du primaire du second transformateur, les nombres de spires de ces secondaires étant très faibles pour limiter l'inductance de fuite.

De plus, classiquement, une forte consommation du circuit est prévue pour maintenir une bonne linéarité en présence de signaux brouilleurs. Mais cette consommation reste élevée même en l'absence de signaux brouilleurs. Un tel circuit n'est donc pas dans les conditions optimales de fonctionnement.

Pour améliorer encore les performances de l'amplificateur, l'invention a pour objet un amplificateur tel que décrit ci-dessus et dans lequel la consommation est adaptée au niveau des signaux détectés, de façon à obtenir dans toutes les conditions de fonctionnement, le meilleur facteur de bruit possible.

Selon l'invention l'amplificateur décrit ci-dessus est en outre caractérisé en ce qu'il comporte un circuit de commande du courant dans le transistor amplificateur comportant des moyens de prélèvement d'une fraction du signal de sortie, un comparateur du signal prélevé avec un signal de référence, dont le signal de sortie commande un circuit à commutation dont le signal de sortie peut prendre l'une ou l'autre de deux valeurs selon que le signal de sortie du comparateur est inférieur ou supérieur à un seuil prédéterminé, les valeurs inférieures à ce seuil étant caractéristiques de signaux d'amplitudes faibles à l'entrée de l'amplificateur, non brouillés tandis que les valeurs supérieures à ce seuil sont caractéristiques de signaux d'amplitudes élevées, comportant des signaux utiles et des signaux brouilleurs.

L'invention sera mieux comprise et d'autres caractéristiques apparaîtront à l'aide de la description qui suit en référence aux figures annexées.

La figure 1 est le schéma électrique d'un mode de réalisation de l'amplificateur selon l'invention ;

La figure 2 est le schéma d'un mode de réalisation particulièrement adapté à l'invention des deux transformateurs utilisés dans le schéma électrique de la figure 1 ;

La figure 3 est le schéma électrique détaillé d'un second mode de réalisation de l'amplificateur selon l'invention.

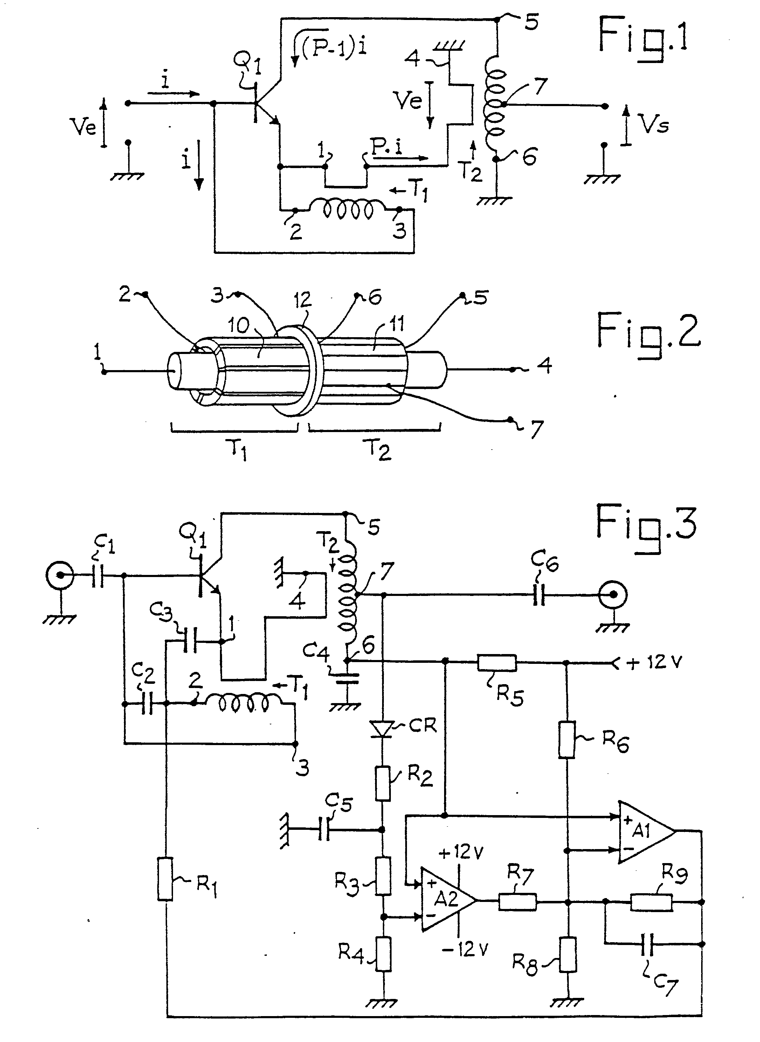

Sur la figure 1 a été représenté un transistor amplificateur $Q_1$. La tension d'entrée $V_e$ est appliquée entre le point de potentiel commun relié à la masse et la base de ce transistor. Le primaire d'un premier transformateur $T_1$ est disposé entre l'émetteur et la base de ce transistor. Le circuit d'émetteur comporte en outre, entre l'émetteur du transistor $Q_1$ et la masse, le secondaire de ce premier transformateur $T_1$ et le secondaire d'un second transformateur $T_2$, en série. Le primaire du transformateur $T_2$ relie le collecteur du transistor $Q_1$ à la masse, et la tension de sortie du montage est prélevée entre une prise intermédiaire du primaire du transformateur $T_2$ et la masse.

Pour ne pas introduire une inductance de fuite trop importante dans le circuit d'émetteur du transistor $Q_1$, les deux secondaires des transformateurs $T_1$ et $T_2$ sont constitués chacun d'une seule spire. $T_1$ est monté en transformateur du courant, et la tension haute fréquence entre le primaire et le secondaire est nulle ; la capacité parasite n'a donc plus d'importance. $T_2$ est monté en transformateur de tension. Sa capacité parasite est toujours gênante vu du collecteur, mais l'autre enroulement, réduit à une seule spire, étant à la masse et à très basse impédance, il n'y a pas de réinjection dans l'amplificateur. Soient P le nombre de spires du primaire du transformateur $T_1$, N le nombre de spires du primaire du transformateur $T_2$ et M le nombre de spires de ce même primaire aux bornes desquelles est prélevée la tension de sortie $V_s$ de l'amplificateur. Pour déterminer les valeurs à donner à P, M, et N, on suppose que le transistor $Q_1$ est idéal, c'est-à-dire que son impédance d'entrée $Z_e$ est infinie, sa tension base émetteur étant nulle.

La tension d'entrée $V_e$ se retrouve aux bornes du secondaire du second transformateur $T_2$, et la tension de sortie $V_s$ est égale a $-MV_e$. Le courant i à l'entrée du montage circule dans le primaire du transformateur $T_1$ qui comporte P spires ; le courant dans la spire du secondaire du transformateur $T_1$ est donc P. i, qui est aussi le courant dans le secondaire du transformateur $T_2$. Les conditions d'équilibre de courant dans le transformateur $T_2$ nécessitent que le nombre d'ampères-tours dans les primaire et secondaire de ce transformateur soient opposés, c'est-à-dire :

$$Pi \cdot 1 = - [(P - 1) \ i \cdot N - M \cdot i_s],$$ $i_s$ étant le courant de sortie. Ce courant de sortie étant égal à $M \cdot i$, l'expression ci-dessus donne :

$$N = M^2 - P/P - 1.$$

M est le gain en tension de l'amplificateur : Si l'on choisit un gain en tension $M = 7$, un certain nombre de solutions sont possibles pour le choix des nombres de spires P et N des primaires des transformateurs $T_1$, et $T_2$:

Avec $M = 7$, les solutions suivantes sont possibles :

si $P = 2$, $N = 47$ ;
si $P = 3$, $N = 23$ ;
si $P = 4$, $N = 15$ ;
si $P = 5$, $N = 11$ ;
si $P = 6$, N est fractionnaire ;
si $P = 7$, $N = 7$.

Dans un mode de réalisation de l'invention la solution retenue est avec $M = 7$, $P = 5$ et $N = 11$.

La figure 2 représente la structure particulière des deux transformateurs, ou les secondaires en série ne font plus qu'un : deux tores en ferrite, 10 et 11, dans le prolongement l'un de l'autre sont séparés par une rondelle isolante 12. Sur le premier sont enroulées les cinq spires du primaire du transformateur $T_1$, et sur le second sont enroulées les onze spires du primaire du transformateur $T_2$. Compte tenu du faible nombre de spires du primaire de $T_1$, les spires ont été formées de deux fils de 0,25 mm de diamètre en parallèle ; le primaire de $T_2$ est constitué d'un fil de 0,2 mm de diamètre. Les secondaires sont constitués d'un simple fil de cuivre qui traverse les deux tores. Une prise est prévue sur le primaire du transformateur $T_2$, à quatre spires. Les points 1, 2, 3, 4, 5, 6 et 7 qui sont les extrémités de bobinage des deux transformateurs sont repérés sur le montage de la figure 1 et sur la figure 2.

La figure 3 représente un second mode de réalisation de l'amplificateur selon l'invention qui comporte les mêmes éléments que l'amplificateur représenté sur la figure 1, désignés par les mêmes repères, et qui comporte en plus, principalement, des moyens pour adapter la consommation du montage aux signaux brouilleurs reçus, de façon à obtenir à tout moment le meilleur facteur de bruit possible. Ce schéma comporte également en plus des capacités de liaison, $C_1$ entre l'entrée du montage et la base de $Q_1$, $C_3$ entre l'émetteur du transistor $Q_1$ et la borne 2 du primaire du transformateur $T_1$, $C_6$ entre la prise intermédiaire 7 et la sortie du montage, ainsi qu'une capacité de découplage $C_4$ entre la borne 6 du primaire du transformateur $T_2$ et la masse et une capacité de compensation haute fréquence $C_2$ entre la base du transistor $Q_1$ et la borne 2 du transformateur $T_1$.

Pour adapter la consommation aux signaux reçus, le circuit comporte en outre un système de commutation rapide du débit de l'amplificateur constitué de la manière suivante : une diode CR en série avec trois résistances $R_2$, $R_3$ et $R_4$ est prévue entre la prise de sortie, 7, du transformateur $T_2$ et la masse. Une capacité de découplage $C_5$ est branchée entre le point commun aux résistances $R_2$ et $R_3$ et la masse. La borne 6 du primaire du transformateur $T_2$ est reliée à une résistance $R_5$ reliée d'autre part à une tension d'alimentation $+12V$. L'information concernant le signal brouilleur est donc détectée à haute impédance, pour ne pas détruire les qualités de linéarité de l'amplificateur, et disponible entre le point commun aux résistances $R_3$ et $R_4$, relié à l'entrée « - » de l'amplificateur opérationnel $A_2$ monté en comparateur, et l'entrée « + » reliée à la borne 6 du primaire du transformateur $T_2$. Le signal de sortie de cet amplificateur $A_2$ est appliqué via une résistance $R_7$ à l'entrée « - » d'un amplificateur opérationnel $A_1$ dont le gain est commuté en fonction du signal de sortie de l'amplificateur $A_2$. Pour cela, un potentiel de référence est également appliqué a l'entrée « - » de l'amplificateur $A_1$ par l'intermédiaire d'un diviseur de tension formé des résistances $R_6$ et $R_8$, entre la source d'alimentation $+12$ volts et la masse. L'entrée « + » de l'amplificateur $A_1$ est reliée au même potentiel que l'entrée « + » du comparateur $A_2$. Cet amplificateur $A_1$ a sa sortie bouclée sur son entrée « - » par l'intermédiaire d'un circuit à résistance $R_9$ et capacité $C_7$. Cette sortie est reliée par l'intermédiaire d'une résistance $R_1$, à la borne 2 du primaire du transformateur $T_1$. La résistance $R_1$ et le pont de résistances $R_6$, $R_8$ ainsi que la résistance $R_9$ dans le circuit de contre-réaction de l'amplificateur $A_1$ permettent d'ajuster le signal de sortie de l'amplificateur $A_1$. La résistance $R_7$ placée entre la sortie du comparateur $A_2$ et l'entrée « - » de l'amplificateur $A_1$ permet d'ajuster la variation de gain obtenue par la commutation. L'information courant prélevée ainsi aux bornes d'une résistance de faible valeur R5 est appliquée à l'amplificateur $A_1$ utilisé en régulateur de courant pour le transistor amplificateur $Q_1$.

Dans un mode de réalisation particulier, ce montage a permis d'obtenir les performances suivantes. une commutation du courant consommé de 25 milliampères à 75 milliampères est commandée par ce circuit pour un seuil de tension d'entrée $V_e$ de 150 millivolts. Son temps de commutation est égal à 30 microsecondes.

L'amplificateur a un gain de 16db ; le facteur de bruit avec un courant consommé égal à 25 milliampères est égal à 2,5 décibels tandis qu'avec un courant consommé de 75 milliampères ce facteur de bruit est égal à 5 décibels. Par ailleurs, avec le courant élevé, soit 75 milliampères, le point de compression à 1 décibel est obtenu pour une tension d'entrée $V_e = 700$ millivolts ; la bande passante à 3 décibels de cet amplificateur est comprise entre 12 mégahertz et 200 mégahertz, et en pratique son utilisation est prévue dans la gamme 30 à 90 mégahertz.

L'invention n'est pas limitée aux modes de réalisation précisément décrits ci-dessus. En particulier la structure spéciale des deux transformateurs dont les secondaires sont en série, tels que représentés sur la figure 2 peut être adaptée en fonction des besoins et les nombres de spires utilisés peuvent être modifiés en particulier en suivant les valeurs indiquées ci-dessus, permettant d'obtenir l'équilibre des courants dans l'amplificateur.

## Revendications

1. Amplificateur a large bande et faible bruit, en ondes métriques, comportant un transistor ($Q_1$) associé à un circuit à transformateur de contre-réaction, caractérisé en ce que le circuit a transformateur comporte deux transformateurs, le primaire du premier ($T_1$) étant branché entre l'émetteur du transistor et sa base, le primaire du second ($T_2$) étant branché entre le collecteur du transistor et le point de potentiel commun, et les secondaires de ces deux transformateurs étant branchés en série dans le circuit d'émetteur du transistor, le signal de sortie de l'amplificateur étant prélevé sur une partie du primaire du second transformateur ($T_2$), les nombres de spires de ces secondaires étant très faibles pour limiter l'inductance de fuite.

2. Amplificateur selon la revendication 1, caractérisé en ce que les secondaires des deux transformateurs comportent chacun une seule spire.

3. Amplificateur selon la revendication 2, caractérisé en ce que les deux transformateurs comporte chacun un tore de ferrite (10, 11), sur lesquels sont enroulées les spires des primaires des transformateurs, places dans le prolongement l'un de l'autre et séparés par une rondelle isolante (12), les secondaires étant formés par un fil qui traverse les deux tores.

4. Amplificateur selon l'une des revendications 2 et 3, caractérisé en ce que le gain en tension de l'amplificateur étant égale à M, la tension de sortie est prélevée aux bornes de M spires du primaire du second transformateur, les primaires des deux transformateurs comportant respectivement P et N spires, P, M, N étant des nombres entiers satisfaisant l'expression $N = M^2 - P/P - 1$.

5. Amplificateur selon l'une des revendications 1 à 4, caractérisé en ce qu'il comporte en outre un circuit de commande du courant dans le transistor amplificateur comportant des moyens de prélèvement d'une fraction du signal de sortie (CR, $R_2$, $R_3$, $R_4$), un comparateur ($A_2$) du signal prélevé avec un signal de référence, dont le signal de sortie commande un circuit a commutation ($A_1$) dont le signal de sortie peut prendre l'une ou l'autre de deux valeurs selon que le signal de sortie du comparateur est inférieur ou supérieur à un seuil prédéterminé, les valeurs inférieures à ce seuil étant caractéristiques de signaux d'amplitudes faibles à l'entrée de l'amplificateur, non brouillés tandis que les valeurs supérieures à ce seuil sont caractéristiques de signaux d'amplitudes élevées, comportant des signaux utiles et des signaux brouilleurs.

6. Amplificateur selon la revendication 5, caractérisé en ce que le circuit à commutation est un amplificateur opérationnel bouclé dont l'entrée « - » reçoit un signal fonction du signal de sortie du comparateur et dont l'entrée « + » reçoit un signal de référence, le signal de sortie de cet amplificateur opérationnel étant appliqué au transistor amplificateur (Q1).

## Claims

1. A low-noise broadband amplifier for VHF waves, comprising a transistor ($Q_1$) associated to a feedback transformer circuit, characterized in that the transformer circuit comprises two transformers, the primary winding of the first transformer ($T_1$) being inserted between the emitter of the transistor and its base, the primary winding of the second transformer ($T_2$) being inserted between the collector of the transistor and the point of common potential, whereas the secondary windings of these two transformers are series connected and integrated in the emitter circuit of the transistor, the amplifier output signal being taken off across a portion of the primary winding of the second transformer ($T_2$), the number of turns of the secondary windings being very small in order to restrict the leakage inductance.

2. An amplifier according to claim 1, characterized in that the secondary windings of both transformers each comprise a single turn.

3. An amplifier according to claim 2, characterized in that each one of the transformers comprises a ferrite torus (10, 11), around which are wound the primary winding windings of the transformers, the transformers being placed in axial alignment and being separated by an insulating washer (12), the secondary windings being formed by a wire which passes through both tori.

4. An amplifier according to one of claims 2 and 3, characterized in that, the voltage gain of the amplifier being equal to M, the output voltage is delivered by the terminals of the M turn of the primary winding of the second transformer, the primary windings of the two transformers comprising respectively P and N windings, P, M, N being integer numbers that satisfy the expression $N = (M^2 - P)/(P - 1)$.

5. An amplifier according to one of claims 1 to

4, characterized in that it further includes a current control circuit contained in the amplifier transistor, comprising means for taking a fraction of the output signal (CR, $R_2$, $R_3$, $R_4$), and a comparator ($A_2$) for comparing said fraction with a reference signal, the comparator output signal controlling a switching circuit ($A_1$), whose output signal may assume the one or the other of the two values, depending upon whether or not the output signal of the comparator is lower or higher than a predetermined threshold, the values below this threshold signifying noise-free signals of low amplitude at the input of the amplifier, whereas the values above that threshold signify high amplitude signals which comprises useful signals and noise signals.

6. An amplifier according to claim 5, characterized in that the switching circuit is a looped operational amplifier, whose negative input « - » receives a signal depending upon the output signal of the comparator, and whose positive input « + » receives a reference signal, the output signal of this operational amplifier being applied to the amplifier transistor ($Q_1$).

**Patentansprüche**

1. Rauscharmer Breitbandverstärker für Meterwellen, mit einem Transistor ($Q_1$), der mit einem gegengekoppelten Transformatorkreis verbunden ist, dadurch gekennzeichnet, daß der Transformatorkreis zwei Transformatoren aufweist, wobei die Primärwicklung des ersten Transformators ($T_1$) zwischen den Emitter des Transistors und seine Basis und die Primärwicklung des zweiten Transformators ($T_2$) zwischen den Kollektor des Transistors und den gemeinsamen Potentialpunkt eingefügt ist, während die Sekundärwicklungen der beiden Transformatoren in Reihe in den Emitterkreis des Transistors eingefügt sind, wobei das Ausgangssignal des Verstärkers an einem Teil der Primärwicklung des zweiten Transformators ($T_2$) abgegriffen wird und die Windungszahlen dieser Sekundärwicklungen zur Begrenzung der Streuinduktivität sehr klein gehalten sind.

2. Verstärker nach Anspruch 1, dadurch gekennzeichnet, daß die Sekundärwicklungen der beiden Transformatoren jeweils eine einzige Windung aufweisen.

3. Verstärker nach Anspruch 2, dadurch gekennzeichnet, daß die beiden Transformatoren je einen Ferritring (10, 11) aufweisen, auf den die Primärwicklung je eines der Transformatoren aufgewickelt ist, wobei die beiden Transformatoren in Verlängerung zueinander angeordnet und durch einen Isolierring (12) voneinander getrennt sind und die Sekundärwicklungen aus einem Draht bestehen, der die beiden Ferritringe durchquert.

4. Verstärker nach einem der Ansprüche 2 und 3, dadurch gekennzeichnet, daß die Ausgangsspannung an den Klemmen von M Windungen der Primärwicklung des zweiten Transformators entnommen wird, wobei M der Spannungsverstärkungsfaktor des Verstärkers ist und wobei die Primärwicklungen der beiden Transformatoren jeweils P und N Windungen aufweisen und P, M, N ganze Zahlen sind, die der Formel N = ($M^2$ — P)/(P — 1) genügen.

5. Verstärker nach einem der Ansprüche 1 bis 4, dadurch gekennzeichnet, daß er weiter im einen Kreis zur Stromsteuerung im Verstärkertransistor aufweist, der Mittel zum Abnehmen eines Teils des Ausgangssignals (CR, $R_2$, $R_3$, $R_4$) und einen Komparator ($A_2$) zum Vergleich des abgenommenen Signals mit einem Bezugssignal besitzt, wobei das Ausgangssignal des Komparators einen Schaltkreis ($A_1$) steuert, dessen Ausgangssignal den einen oder den anderen von zwei Werten annehmen kann, je nachdem, ob das Ausgangssignal des Komparators kleiner oder größer als ein vorbestimmter Schwellwert ist, wobei die diesen Schwellwert unterschreitenden Werte typisch für nicht gestörte Signale schwacher Amplitude am Verstärkereingang sind, während die diesen Schwellwert überschreitenden Signale typisch für Signale mit hoher Amplitude sind und sowohl Nutzsignale als auch Störsignale enthalten.

6. Verstärker nach Anspruch 5, dadurch gekennzeichnet, daß der Schaltkreis ein rückgekoppelter Operationsverstärker ist, dessen Minuseingang « - » ein Signal in Abhängigkeit vom Ausgangssignal des Komparators und dessen Pluseingang « + » ein Bezugssignal empfängt, wobei das Ausgangssignal dieses Operationsverstärkers an den Verstärkertransistor ($Q_1$) angelegt ist.

# Fig.1

# Fig.2

# Fig.3